Europäisches Patentamt

European Patent Office

Office européen des brevets

(19)

(11) Numéro de publication: **0 151 080**
**B1**

(12) # FASCICULE DE BREVET EUROPÉEN

(45) Date de publication du fascicule du brevet:
04.11.87

(21) Numéro de dépôt: 85400146.8

(22) Date de dépôt: 29.01.85

(51) Int. Cl.⁴: **H 03 F 1/30,** H 04 N 5/14,
H 04 N 5/68

(54) Circuit de transposition de niveau utilisable pour imagerie vidéo à haute définition.

(30) Priorité: 02.02.84 FR 8401598

(43) Date de publication de la demande:
07.08.85 Bulletin 85/32

(45) Mention de la délivrance du brevet:
04.11.87 Bulletin 87/45

(84) Etats contractants désignés:
DE GB

(56) Documents cité:
GB-À-1 313 152
US-A-4 293 875

(73) Titulaire: THOMSON- CSF, 173, Boulevard
Haussmann, F-75379 Paris Cédex 08 (FR)

(72) Inventeur: Henry, Michel, THOMSON- CSF SCPI
173, bld Haussmann, F-75379 Paris Cedex 08 (FR)

(74) Mandataire: Trocellier, Roger, THOMSON- CSF
SCPI 19, avenue de Messine, F-75008 Paris (FR)

LIBER, STOCKHOLM 1987

## Description

La présente invention concerne un circuit de transposition de niveau dont l'application est envisagée, en particulier, pour réaliser un dispositif d'imagerie vidéo à haute définition.

Le circuit objet de l'invention, a pour but d'assurer la liaison dynamique entre deux circuits dont les points de fonctionnement diffèrent. En effectuant la transposition de niveau nécessitée par ces points distincts de fonctionnement, le circuit de transposition permet ainsi le fonctionnement de chaque circuit selon ses caractéristiques propres, sans affecter la réponse dynamique de l'ensemble et également sans entraîner de dérive continue de fonctionnement.

Cette fonction d'adaptation à des points de fonctionnement différents se présente, par exemple, dans le montage terminal d'une imagerie vidéo pour connecter la sortie de l'amplificateur vidéo à la cathode du canon électronique du tube à rayons cathodiques de visualisation, noir et blanc ou couleur.

L'amplificateur vidéo est généralement réalisé avec des transistors, par exemple un montage cascode. Bien que les transistors peuvent atteindre une fréquence élevée de fonctionnement, leur tension de claquage (tension VCE entre collecteur et émetteur) va rarement au-delà de 60 V. Or, les points de fonctionnement des tubes cathodiques, qu'ils soient noir et blanc ou couleur, sont de l'ordre de 100 V, ou de 150 V. Il y a donc pour un tel ensemble une incompatibilité à résoudre, ces circuits ne pouvant être reliés directement sans risque de perturbation et défaut de fonctionnement de l'une ou l'autre des parties.

Pour résoudre le problème précité, différentes solutions existent dont on rappellera succinctement les principales.

Une première solution consiste à utiliser une liaison alternative grâce à une capacité et à monter un circuit de calage de niveau ("clamping" en anglais) sur la liaison de polarisation de la cathode du tube cathodique. Une deuxième solution utilise aussi des liaisons capacitives avec restitution par diode sur la polarisation du tube. Une troisième solution comporte des aménagements au niveau de la référence continue de l'amplificateur vidéo.

Ces solutions donnent de bons résultats pour des chaines vidéo conventionnelles qui n'exigent pas une bande passante trop élevée, la valeur se situant généralement autour de 20 MHz.

Pour des réalisations dites à haute définition où la qualité de l'image est accrue par une augmentation du nombre de lignes et du nombre de points par lignes, cette bande passante est beaucoup plus grande; les fréquences hautes atteignent, par exemple, 100 MHz environ pour 2000 points/2000 lignes.

Les transistors acceptent une telle bande de fonctionnement mais les solutions évoquées pour la liaison dynamique au tube peuvent donner satisfaction par leur relative complexité qui entraîne rapidement une dégradation de la réponse dynamique, ou par le nombre de composants utilisés qui introduisent une capacité parasite élevée, ou par des défauts de faisabilité de certains composants à ces fréquences, ou encore que la difficulté se trouve reportée en amont au niveau de l'amplificateur vidéo.

Le circuit de transposition proposé permet de résoudre le problème évoquée et toute configuration similaire en mettant en oeuvre un circuit simple qui présente en outre de multiples avantages.

Suivant l'invention, il est réalisé un circuit de transposition de niveau pour relier une sortie dynamique d'un premier circuit à l'entrée correspondante d'un deuxième circuit dont les points de fonctionnement diffèrent, caractérisé en ce qu'il comporte trois éléments connectés en parallèle entre ladite sortie et ladite entrée, ces trois éléments groupant une capacite, un potentiomètre par ses bornes terminales, et un transistor par ses électrodes collecteur et émetteur, ainsi qu'une résistance de charge interposée sur la connexion d'alimentation reliant l'une desdites électrodes à une alimentation haute tension annexe, ledit transistor etant connecté par son électrode de base au curseur du potentiomètre en sorte d'ajuster la transposition de niveau entre ladite sortie et ladite entrée.

Les avantages principaux de ce montage sont les suivants: il est apériodique, permet une large plage de transposition, comporte peu de composants, son réglage est simple et indépendant du point de fonctionnement du circuit amplificateur en amont, il est autostabilisé en dérive continue.

Les particularités de l'invention apparaîtront dans la description qui suit donnée à titre d'exemple à l'aide des figures annexées qui représentent:

- la figure 1 un schéma général d'un circuit de transposition conforme à l'invention;
- la figure 2 un schéma équivalent pour montrer le fonctionnement;
- la figure 3 un schéma d'une utilisation envisagée pour imagerie à haute fréquence;
- la figure 4 une forme d'onde illustrant la réponse du montage selon la figure 3 à un signal donné.

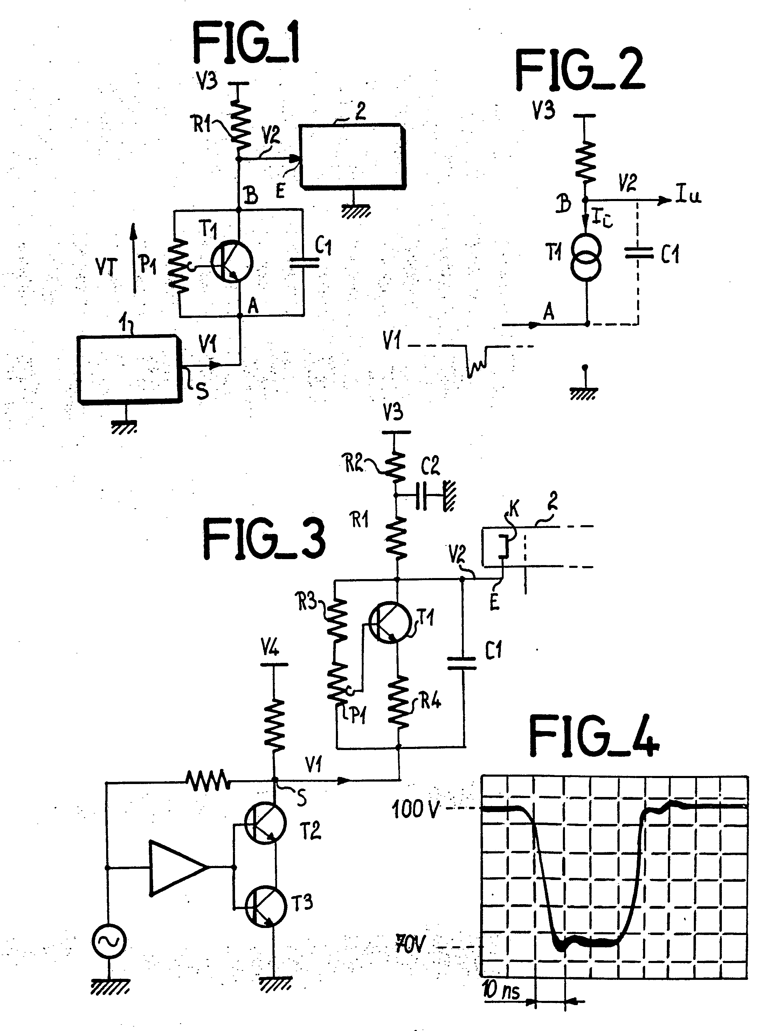

En se reportant à la figure 1, le circuit de transposition interposé entre la sortie dynamique S d'un premier circuit 1 et l'entrée correspondante E d'un deuxième circuit 2, permet d'adapter l'ensemble aux points de fonctionnement indiqués par les niveaux V1 et V2 présentés en l'absence de signal. Pour la réalisation figurée qui est la plus fréquente, le niveau V2, ou point de fonctionnement du circuit 2, est supérieur à celui V1 du circuit 1.

Le circuit de transposition comporte, connectes en parallèle entre la sortie S et l'entrée E une capacité C1, un potentiomètre P1 par ses bornes d'extrémités et un transistor T1 par ses électrodes collecteur et émetteur. Le curseur du potentiomètre P1 est relié à l'électrode de base du transistor T1. Celui-ci est connecté à travers une résistance de charge R1 à une haute tension continue d'alimentation V3. Dans le cas d'un transistor "npn" figuré, le collecteur est connecte à la résistance de charge R1 et à l'entrée E du circuit 2.

L'ensemble T1, P1 alimenté via R1 se comporte comme une diode Zener ajustable par réglage du curseur de P1. Ce réglage fait varier la polarisation base-émetteur du transistor et donc sa conduction, c'est-à-dire le courant collecteur Ic qui le traverse (figure 2). En conséquence, on peut régler la tension entre les bornes A et B du transistor et réaliser l'ajustement de niveau désiré dès que la tension entre ces bornes égale la différence V2 - V1 des points de fonctionnement.

Comme on peut le voir plus aisément avec l'exemple figure 1, le point de fonctionnement V1 est fixé en S par le circuit 1 et le montage doit produire la valeur de transposition VT telle que V2 = V1 + VT pour atteindre le point de fonctionnement V2 en E. Par le réglage de P1 on fait varier le courant Ic jusqu'à ce que la chute de tension dans la résistance R1 permet d'obtenir la valeur V2 nécessaire pour l'exploitation. Cette chute de tension est due au courant Ic du transistor et au courant Iu d'utilisation pour le circuit 2.

La capacité C1 transmet les fronts de montée et de descente de l'information vidéo et assure ainsi la transmission des fréquences hautes de la bande passante du signal.

L'auto-stabilisation du montage envers les dérives thermiques peut être montrée aisément. On suppose par exemple une variation qui produit un accroissement du courant Iu d'utilisation, ce qui tend à diminuer la tension V2 et se répercute sur la base de T1 à travers P1. Le courant de base se trouve réduit ce qui entraîne une réduction du courant collecteur Ic. Consécutivement, il se produit une diminution de tension aux bornes de R1 et un accroissement de la tension en B qui compense sensiblement la diminution de V2 par dérive thermique.

Sur l'exemple figure 3 on a représenté la cathode K d'un tube cathodique 2 alimenté à la tension V2 à partir de la haute tension V3. La tension V1 est de même obtenue à partir de la haute tension V4. Les valeurs des tensions sont par exemple V4 = + 60 V, V1 = + 50 V, V3 = + 120 V, V2 = + 100V. L'amplificateur vidéo comporte en sortie un montage cascode de transistors T2, T3. Le circuit R2 C2 indiqué permet de filtrer les résidus de filtrage de l'alimentation continue V3, il peut être supprimé si l'alimentation est de bonne qualité. Le circuit de transposition peut être réalisé à l'aide des éléments suivants: transistor T1 du type 2N3501, C1 = 47nF, C2 = 0,1μF, P1 = 4,7KΩ, R1 = 5,6KΩ, R2 = 100Ω, R3 = 3,9KΩ, R4 = 100Ω pour les valeurs V1 à V4 précitées.

La résistance R3 en série avec P1 permet de limiter la polarisation maximale réglable de la base de T1 par rapport à l'émetteur.

La résistance R4 reliée à l'émetteur de T1 permet de linéariser la commande par introduction d'une contre-réaction continue.

La figure 4 montre la réponse dynamique en E du montage figure 3 pour un signal en S variant de V1 à (V1 - 30 V), le niveau V2 est réglé à 100 V, le balayage en X représente 10 ns/cm. Cette forme d'onde permet d'apprécier le passage de fréquences hautes supérieures à 100 MHz.

Parmi les variantes possibles, le transistor T1 peut être du type "pnp", dans ce cas c'est l'électrode émetteur qui est connectée du côté R1 et E, et l'électrode collecteur du côté S.

**Revendications**

1. Circuit de transposition de niveau pour relier une sortie dynamique d'un premier circuit à l'entrée correspondante d'un deuxième circuit dont les points de fonctionnement diffèrent, caractérisé en ce qu'il comporte trois éléments connectés en parallèle entre ladite sortie et ladite entrée, ces trois éléments groupant une capacité (C1), un potentiomètre (P1) par ses bornes terminales, et un transistor (T1) par ses électrodes collecteur et émetteur, ainsi qu'une résistance de charge (R1) interposé sur la connexion d'alimentation reliant l'une desdites électrodes à une alimentation haute tension annexe (V3), ledit transistor étant connecté par son électrode de base au curseur du potentiomètre en sorte d'ajuster la transposition de niveau entre ladite sortie et ladite entrée.

2. Circuit selon la revendication 1, caractérisé en ce qu'il produit une transposition de niveau positive pour passer d'un point de fonctionnement déterminé (V1) en ladite sortie à un point plus élevée (V2) en ladite entrée.

3. Circuit selon la revendication 2, caractérisé en ce qu'il utilise un transistor "npn" connecté côté collecteur à l'entrée (E) du deuxième circuit (2).

4. Circuit selon la revendication 2, caractérisé en ce qu'il utilise un transistor "pnp" connecté côté émetteur à l'entrée (E) du deuxième circuit (2).

5. Circuit selon l'une quelconque des revendications précédentes, utilisé dans un système d'imagerie vidéo à haute définition, caractérisé en ce qu'il est interposé entre un amplificateur vidéo terminal (1, T2 - T3) et le tube cathodique de visualisation (2) pour y alimenter une cathode (K).

**Patentansprüche**

1. Schaltkreis zur Pegelumsetzung, um einen dynamischen Ausgang eines ersten Kreises an den entsprechenden Eingang eines zweiten Kreises mit unterschiedlichem Arbeitspunkt anzuschließen, dadurch gekennzeichnet, daß er drei Elemente enthält, die parallel zwischen den genannten Ausgang und den genannten Eingang angeschlossen sind und einen Kondensator (C1), ein Potentiometer (P1) mit seinen Endklemmen und einen Transistor (T1) mit seiner Kollektor-Emitterstrecke umfassen, und daß weiter ein Ladewiderstand (R1) in die Speiseverbindung eingefügt ist, die die Emitter-Kollektorstrecke an eine angegliederte Hochspannungsversorgung (V3) anschließt, wobei der Transistor mit seiner Basiselektrode an den Zwischenangriff des Potentiometers angeschlossen ist, so daß die Pegelumsetzung zwischen dem genannten Ausgang und dem genannten Eingang eingestellt werden kann.

2. Schaltkreis nach Anspruch 1, dadurch gekennzeichnet, daß er eine positive Pegelumsetzung durchführt, um von einem bestimmten Arbeitspunkt (V1) an dem genannten Ausgang zu einem hoheren Arbeitspunkt (V2) an dem genannten Eingang zu gelangen.

3. Schaltkreis nach Anspruch 2, dadurch gekennzeichnet, daß er einen npn-Transistor verwendet, dessen Kollektor an den Eingang (E) des zweiten Kreises (2) angeschlossen ist.

4. Schaltkreis nach Anspruch 2, dadurch gekennzeichnet, daß er einen pnp-Transistor verwendet, dessen Emitter an den Eingang (E) des zweiten Kreises (2) angeschlossen ist.

5. Schaltkreis nach einem beliebigen der vorhergehenden Anspruche, der in einem hochauflösenden Videobildsystem verwendet wird, dadurch gekennzeichnet, daß er zwischen einen Bildendverstärker (1, T2-T3) und die Kathodenstrahl-Bildröhre (2) eingefügt ist, um dort eine Kathode (K) zu speisen.

**Claims**

1. A level transposition circuit conceived to connect a dynamic output of a first circuit to the corresponding input of a second circuit, the operating points of the two circuits being different, characterized in that it comprises three elements which are connected in parallel and are interposed between said output and said input, these three elements including a capacitor (C1), a potentiometer (P1) via its main terminals and a transistor (T1) via its collector and emitter electrodes, and that it comprises a charge resistor (R1) inserted in the power supply connection between one of said electrodes and an associated high voltage source (V3), said transistor being connected by its base electrode to the pick-off terminal of the potentiometer, such that the level transposition betweeen said output and said input can be adjusted.

2. A circuit according to claim 1, characterized in that it realizes a positive level transposition in order to transit from a predetermined operating point (V1) at that output to a higher point (V2) at said input.

3. A circuit according to claim 2, characterized in that it uses a npn-transistor, the collector of which is connected to the input (E) of the second circuit (2).

4. A circuit according to claim 2, characterized in that it uses a pnp-transistor, the emitter of which is connected to the input (E) of the second circuit (2).

5. A circuit according to any one of the preceding claims used in a high definition video picture system, characterized in that it is inserted between a terminal video amplifier (1, T2-T3) and the display cathode ray tube (2) in order to supply a cathode (K) thereof.

0 151 080

FIG_1

FIG_2

FIG_3

FIG_4

100 V

70V

10 ns